(19) Europäisches Patentamt
European Patent Office
Office européen des brevets

(11) **EP 2 388 620 B1**

(12) **FASCICULE DE BREVET EUROPEEN**

(45) Date de publication et mention
de la délivrance du brevet:
**22.08.2012 Bulletin 2012/34**

(51) Int Cl.:
*G01S 19/29* $^{(2010.01)}$     *H03L 7/085* $^{(2006.01)}$

(21) Numéro de dépôt: **11162117.3**

(22) Date de dépôt: **12.04.2011**

(54) **Dispositif de discrimination de la phase et de la variation de phase d'un signal**

Vorrichtung zur Phasendiskriminierung und zur Diskriminierung der Phasenänderung eines Signals

Apparatus for discriminating the phase and the phase variation of a signal

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **21.05.2010 FR 1002152**

(43) Date de publication de la demande:
**23.11.2011 Bulletin 2011/47**

(73) Titulaire: **Thales
92200 Neuilly Sur Seine (FR)**

(72) Inventeurs:
• **Martin, Nicolas
26500 Bourg les Valence (FR)**

• **Perre, Jean-Michel
07130 St Peray (FR)**

(74) Mandataire: **Lucas, Laurent Jacques
Marks & Clerk France
Conseils en Propriété Industrielle
Immeuble Visium
22, Avenue Aristide Briand
94117 Arcueil Cedex (FR)**

(56) Documents cités:
**FR-A1- 2 913 773     US-A1- 2005 100 106
US-B1- 7 702 040**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

Le domaine technique de l'invention est celui des dispositifs de démodulation d'un signal dans un système de réception pour lequel une estimation précise de la phase est nécessaire. L'invention s'applique en particulier aux systèmes de radionavigation par satellite pour lesquels l'information contenue dans la phase du signal contribue à déterminer précisément la position d'un récepteur.

L'invention concerne un dispositif de discrimination ou estimation de la phase ou erreur de phase lors de la démodulation d'un signal soumis à des variations de phase importantes, par exemple dues à une évolution rapide de la fréquence due à l'effet Doppler. Dans la suite de la description l'utilisation du terme fréquence Doppler est faite en référence à un biais de fréquence due à la vitesse de l'émetteur ou du récepteur, par rapport à la fréquence nominale en absence de mouvement du porteur.

Un système de radionavigation par satellite a pour but de déterminer la position d'un récepteur en utilisant le principe de la triangulation. Les pseudo-distances mesurées à partir des signaux reçus par trois satellites sont exploitées pour déterminer la position du récepteur.

Outre la précision du positionnement, deux autres paramètres caractérisent les performances d'un récepteur de radio-navigation : la capacité à fonctionner avec un faible rapport signal à bruit et la tenue à la dynamique de phase due aux mouvements du porteur. Dans le cas où le porteur est un avion, les accélérations de mouvement qu'il est susceptible d'engendrer se traduisent par une variation de fréquence Doppler importante sur les signaux reçus par le récepteur.

Les moyens de démodulation des signaux reçus par le récepteur utilisent, le plus souvent, le principe connu de boucle à verrouillage de phase pour estimer précisément la phase des signaux reçus afin de déterminer un positionnement précis. Les performances d'une boucle à verrouillage de phase (PLL) sont caractérisées notamment par deux critères, sa tenue aux variations rapides de fréquence Doppler et sa capacité à fonctionner à un faible rapport signal à bruit. Un compromis est nécessaire entre ces deux paramètres, ainsi, l'augmentation de la tenue aux variations de fréquence Doppler se fait au prix d'une résistance moindre au bruit. De plus, elle nécessite une augmentation de la bande passante de la boucle ce qui entraîne un surcoût en charge de calcul pour le récepteur.

Le problème visé par la présente invention consiste à augmenter sensiblement la tenue à la dynamique de phase sans augmenter le point de fonctionnement en rapport signal à bruit du système et en limitant la charge de calcul.

La tenue à la dynamique des boucles à verrouillage de phase connues est restreinte par le discriminateur de phase qui présente une plage linéaire limitée. La tenue à la dynamique d'une boucle à verrouillage de phase représente sa capacité à tolérer un changement important entre deux états stationnaires. En cas de traînage de ladite boucle, encore appelée boucle de porteuse, pendant la phase transitoire entre les deux états stationnaires, l'erreur de phase peut sortir de la zone de capture du discriminateur ce qui peut entraîner la divergence de la boucle et son décrochage.

Afin d'augmenter l'étendue de la zone de capture de la boucle de phase, il est connu de mettre en oeuvre un discriminateur dit « enrouleur » qui enregistre le nombre de tours sur l'erreur de phase ce qui a pour conséquence que la zone de capture devient infinie en erreur de phase. Elle reste cependant limitée en erreur de fréquence ou erreur de vitesse de phase. Cette limitation est directement liée à la fréquence d'échantillonnage utilisée par le dispositif numérique qui exécute la boucle. Dans un récepteur de radionavigation par satellite, la limitation de la fréquence d'échantillonnage de la boucle de phase est liée à la durée d'intégration cohérente appliquée pour démoduler le signal reçu.

Cette limite en fréquence peut être pénalisante dans le cas d'applications, par exemple aéroportées, induisant de fortes variations de vitesse de phase.

Une autre solution connue est décrite dans la demande de brevet français n° 07 01931 du demandeur qui porte sur un dispositif de réception de signaux satellitaires comprenant une boucle de phase avec compensation des retards. Cette solution permet d'augmenter la bande passante de la boucle sans la rendre instable, ce qui a pour effet d'augmenter la tenue à la dynamique de la boucle sans augmenter la bande de pré-détection du système donc sans alourdir la charge de calcul des boucles.

Cependant, cette solution, bien que permettant de réduire le traînage de la boucle de phase et ainsi d'améliorer la tenue à la dynamique ne change pas la limite de fonctionnement en fréquence du discriminateur qui constitue toujours le facteur limitant.

Une autre solution connue consiste à utiliser directement une boucle à verrouillage de fréquence mais dans ce cas, la mesure de phase est beaucoup moins précise ce qui est pénalisant pour les performances en terme de précision et d'intégrité de la mesure de positionnement.

La présente invention permet de pallier les limitations des solutions connues précitées en utilisant un discriminateur enrouleur étendu en fréquence.

A cet effet l'invention a pour objet un dispositif discriminateur de phase recevant en entrée un signal complexe dont l'argument représente une erreur de phase $\Delta\varphi$ et produisant en sortie une estimée $\theta_{n+1}$ de l'erreur de phase $\Delta\varphi$ pour chaque échantillon de signal $Z_{n+1}$ reçu, caractérisé en ce qu'il comporte des moyens de calculs adaptés à déterminer l'estimée de phase obtenue à un instant $(N+1)T_1$ à l'aide des relations suivantes:

$$\theta_{n+1} = \theta_n + \Delta\theta_{n+1} + \Delta\theta'_{n+1}$$

$$\Delta\theta'_{n+1} = Discri_{Fréquence}(n+1).2\pi.T_1$$

$$\Delta\theta_{n+1} = \arctan(I'_{n+1}, Q'_{n+1})$$

$$I'_{n+1} + jQ'_{n+1} = Z_{n+1}.Z'^{*}_{n+1}$$

$$Z'_{n+1} = \exp(j\Delta\theta'_{n+1}).Z_n$$

où $T_1$ est l'intervalle de temps entre deux échantillons $Z_n$ et $Z_{n+1}$ consécutivement reçus, Discri$_{fréquence}$(n+1) est une estimée de l'erreur de fréquence $\partial\Delta\varphi/\partial t$ dudit signal complexe produite par un discriminateur de fréquence que comporte ledit dispositif, et $Z'^{*}_{n+1}$ est le complexe conjugué de $Z'_{n+1}$.

Dans une variante de réalisation de l'invention, le dispositif discriminateur comporte en outre des premiers moyens d'intégration cohérente dudit signal produisant à partir d'un nombre M d'échantillons complexes $Z_{n,k}$ de signal à la fréquence $F'_e = 1/T_0$ un échantillon complexe $Z_n$ à la fréquence $F_e = 1/T_1$, chaque intervalle de temps de durée $T_1$ étant subdivisé en un nombre M d'intervalles de temps de durée $T_0$, ledit discriminateur de fréquence déterminant l'estimée d'erreur de fréquence Discri$_{fréquence}$(n) à partir desdits échantillons $Z_{n,k}$.

Dans une variante de réalisation de l'invention, ledit discriminateur de fréquence comporte au moins des premiers moyens de calcul d'au moins deux hypothèses d'erreur de fréquence selon les fréquences $-F_0$ et $+F_0$ avec $F_0 = F_e/2$ :

$$Z_{+1}(n) = \sum_{k=0}^{M-1} Z(n,k)e^{+j\pi\frac{k}{M}}$$

$$Z_{-1}(n) = \sum_{k=0}^{M-1} Z(n,k)e^{-j\pi\frac{k}{M}} ,$$

et des seconds moyens de calcul de l'estimée d'erreur de fréquence à l'aide d'une des deux relations suivantes :

$$Discri_{Fréquence}(n) = \frac{\left\{\left\|Z_{+1}(n)\right\|^2 - \left\|Z_{-1}(n)\right\|^2\right\}}{(32CT_1/\pi^2)}$$

ou

$$Discri_{Fréquence}(n) = \frac{\mathrm{Re}[(Z_{+1}(n) - Z_{-1}(n)).Z_0(n)^{*}]}{(16CT_1/\pi^2)}$$

avec C la puissance estimée du signal reçu et $Z_0(n) = Z_n$

Dans une variante de réalisation de l'invention, l'estimée d'erreur de fréquence est remplacée par la moyenne des estimées d'erreur de fréquence obtenues aux instants n et n+1.

Dans une variante de réalisation de l'invention, lesdites hypothèses d'erreur de fréquence sont corrigées de l'estimée d'erreur de fréquence obtenue à l'instant précédent :

$$Z_{+1}(n) = \sum_{k=0}^{M-1} Z(n,k) e^{+j\pi\frac{k}{M}} e^{-j2\pi.Discri_{Fréquence}(n-1)}$$

$$Z_{-1}(n) = \sum_{k=0}^{M-1} Z(n,k) e^{-j\pi\frac{k}{M}} e^{-j2\pi.Discri_{Fréquence}(n-1)}$$

et que l'estimée d'erreur de fréquence déterminée à l'instant n-1 est ajoutée à celle obtenue à l'instant n.

Dans une variante de réalisation de l'invention, lesdits premiers moyens de calcul réalisent un nombre 2S d'hypothèses d'erreur de fréquence aux valeurs de fréquence allant de $-SF_0$ à $+SF_0$ par pas de $F_0$ selon les relations

$$Z_{+p}(n) = \sum_{k=0}^{M-1} Z(n,k) e^{+j\pi p\frac{k}{M}} \quad \text{et} \quad Z_{-p}(n) = \sum_{k=0}^{M-1} Z(n,k) e^{-j\pi p\frac{k}{M}} ,$$

que ledit discriminateur de fréquence comporte en outre des moyens de détermination de l'indice $p_0$ associé à la valeur $\|Z_{p0}(n)\|^2$ maximum dans l'ensemble [-(S-1)...,-2,-1,0,1,2,...(S-1)], avec $Z_0(n)=Z_n$ et que l'estimée d'erreur de fréquence est déterminée à l'aide d'une des deux relations suivantes :

$$Discri_{Fréquence}(n) = \frac{\left\{\left\|Z_{p_0+1}(n)\right\|^2 - \left\|Z_{p_0-1}(n)\right\|^2\right\}}{(32CT_1/\pi^2)} + p_0 F_0$$

ou

$$Discri_{Fréquence}(n) = \frac{Re[(Z_{p_0+1}(n) - Z_{p_0-1}(n)).Z_{p_0}(n)^*]}{(16CT_1/\pi^2)} + p_0 F_0$$

Dans une variante de réalisation de l'invention, ledit dispositif discriminateur de phase comporte en outre des moyens d'estimation du rapport signal sur bruit $\hat{RSB}$, des moyens de comparaison dudit rapport signal sur bruit avec un seuil prédéterminé en fonction d'un compromis entre l'étendue de la dynamique en fréquence dudit dispositif et sa résistance au bruit et des moyens de désactivation et d'activation dudit discriminateur de fréquence en fonction du résultat de la comparaison.

Dans une variante de réalisation de l'invention, ledit dispositif discriminateur de phase comporte en outre des moyens d'estimation de la puissance de bruit $\sigma_b^2$, par exemple à l'aide de la relation

$$\sigma_b^2 = \sum_{k=0}^{M-1} \|Z_b(n,k)\|^2$$

avec $Z_b(n,k)$ des échantillons de bruit mesurés et le rapport signal sur bruit est estimé à l'aide d'une des relations suivantes :

$$\hat{RSB} = \frac{\left\|Z_{p_0}(n)\right\|^2}{\sigma_b^2} \; ou \; \hat{RSB} = \frac{\left\|Z_0(n)\right\|^2}{\sigma_b^2}$$

L'invention a également pour objet un dispositif de réception de signaux de radionavigation par satellite recevant un signal continu modulé par une porteuse, de phase $\varphi_{reçue}$, comprenant au moins des moyens permettant de générer une porteuse locale, de phase $\varphi_{locale}$, et des moyens de démodulation et de filtrage dudit signal, caractérisé en ce qu'il comporte en outre des seconds moyens d'intégration cohérente dudit signal qui délivrent en sortie un nombre M d'échantillons $Z_{n,k}$ à une fréquence d'échantillonnage $F'_e$ et une boucle à verrouillage de phase comprenant au moins un dispositif discriminateur de phase selon l'invention qui reçoit en entrée un signal complexe dont l'argument représente l'erreur de phase $\Delta\varphi = \varphi_{locale} - \varphi_{reçue}$ et qui permet d'asservir la phase $\varphi_{locale}$ de la porteuse locale sur celle $\varphi_{reçue}$ de la porteuse reçue.

D'autres caractéristiques apparaîtront à la lecture de la description détaillée donnée à titre d'exemple et non limitative qui suit faite en regard de dessins annexés qui représentent :

La figure 1, un schéma de principe des moyens de démodulation mis en oeuvre par un récepteur de radionavigation par satellite,
La figure 2, une illustration du principe de fonctionnement d'un discriminateur de phase de type arctangente selon l'art antérieur appliqué à une voie pilote,
La figure 3, une illustration du principe de fonctionnement d'un discriminateur de phase de type arctangente selon l'art antérieur appliqué à une voie de données,
La figure 4, une illustration du principe de fonctionnement d'un discriminateur de phase « enrouleur » selon l'art antérieur appliqué à une voie pilote, dans le cas où la boucle de phase ne décroche pas,
La figure 5, une illustration du principe de fonctionnement d'un discriminateur de phase « enrouleur » selon l'art antérieur appliqué à une voie pilote, dans le cas où la boucle de phase décroche,
La figure 6, une illustration du principe de fonctionnement d'un discriminateur de phase « enrouleur » selon l'art antérieur appliqué à une voie de données,
La figure 7, une illustration du principe de fonctionnement d'un discriminateur de phase selon l'invention appliqué à une voie pilote,
La figure 8, un synoptique comparatif d'un discriminateur de phase « enrouleur » et d'un discriminateur de phase selon l'invention,
La figure 9, un schéma de principe de l'évolution de l'erreur de phase sur des sous intervalles d'intégration cohérente,
La figure 10, une illustration du principe utilisé pour construire le discriminateur de fréquence selon l'invention,
La figure 11, une illustration d'une variante d'un discriminateur de fréquence selon l'invention,
La figure 12, une illustration d'une troisième variante d'un discriminateur de fréquence selon l'invention,
La figure 13, une illustration du principe de fonctionnement d'un discriminateur de phase selon l'invention appliqué à une voie de données.

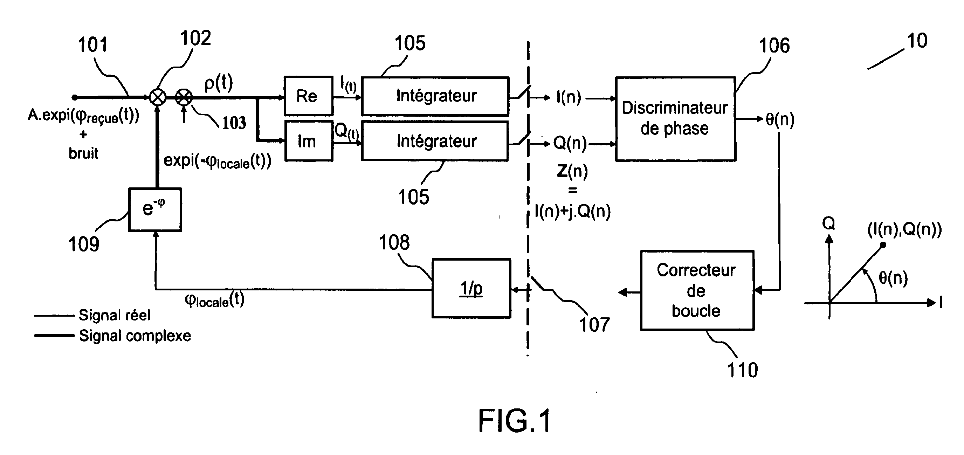

La figure 1 schématise le principe de la démodulation du signal reçu par un récepteur 10 de radionavigation par satellite. Les traitements situés à gauche de la ligne en pointillés constituent un système continu ou discret avec une fréquence d'échantillonnage élevée $F_c$, par exemple égale à 100 MHz. Ils sont réalisés préférentiellement par des circuits intégrés de type ASIC ou FPGA compatibles d'une telle fréquence élevée. Les traitements situés à droite de la ligne en pointillés constituent un système échantillonné à une fréquence basse, par exemple égale à 50 Hz, et sont réalisés par un logiciel, par exemple un logiciel de traitement de signal DSP.

Le signal reçu 101 est démodulé par une porteuse locale 109 de phase $\varphi_{locale}(t)$ par le biais d'un multiplieur complexe 102. Le terme « porteuse locale » désigne un signal généré localement à une seconde fréquence différente de celle du signal reçu, cette seconde fréquence étant commandée grâce à un oscillateur contrôlé numériquement 108. Une seconde démodulation 103 est également appliquée dans le but de démoduler le signal reçu par le code d'étalement local. Des moyens 105 d'intégration cohérente permettent notamment le filtrage du signal reçu 104 démodulé. Le signal complexe $Z(n) = I(n) + jQ(n)$ ainsi obtenu est transmis à un discriminateur de phase 106 qui produit en sortie une estimation $\theta_n$ de l'erreur de phase $\Delta\varphi_n = \varphi_{locale}(n.T) - \varphi_{reçue}(n.T)$ de la porteuse locale par rapport à la phase de la porteuse du signal reçu. Cette estimation alimente un correcteur de boucle 110. Un tel correcteur 110 peut consister par exemple en un intégrateur d'accélération qui exécute la relation suivante : $A(n+1) = A(n) + T.K3.\theta(n)$, associé à un intégrateur de vitesse qui exécute la relation suivante : V(n+1) = V(n) + T.A(n) + T.K2.θ(n). L'oscillateur 108 contrôlé numériquement peut également constituer un intégrateur de phase exécutant la relation suivante : $\varphi_{locale}$((n+1).T)= $\varphi_{locale}$(n.T) + T.V(n) + T.K1.θ(n) s'il reçoit en entrée une commande en vitesse égale à : V(n) + K1.θ(n). Dans cet exemple, la boucle de phase ainsi réalisée est une boucle du 3ème ordre car elle contient trois intégrateurs. L'intégrateur d'accélération permet de supporter une accélération constante sans erreur de traînage en régime permanent. Par contre en régime transitoire, suite à un changement d'accélération, l'erreur de traînage sur la phase peut être importante et le discriminateur 106 doit être capable de suivre l'erreur maximale sans saturer pour que la boucle puisse revenir dans un état stationnaire sans saut de cycle qui serait préjudiciable pour la précision des mesures

Le correcteur de boucle 110 délivre une commande en vitesse 107 qui est produite en entrée d'un oscillateur contrôlé numériquement 108 qui délivre à sa sortie la phase de la porteuse locale $\varphi_{locale}$(t). Ainsi la boucle à verrouillage de phase mise en oeuvre permet d'asservir la phase $\varphi_{locale}$(t) de la porteuse locale sur la phase $\varphi_{reçue}$(t) de la porteuse du signal reçu.

Les discriminateurs de phase connus sont de type « enrouleur». Ils présentent une limitation du fait de l'ambiguïté modulo 2 π sur la phase du signal. Lorsque l'erreur de phase a évolué de π radians, soit un demi tour de cercle, entre deux instants de mesure, il subsiste une ambiguïté sur le signe de cette erreur, à savoir π ou -π. Par construction le discriminateur 106 sait mesurer une variation d'erreur de phase comprise dans l'intervalle [+π -π[. En présence de variation forte de la phase, le discriminateur mesure une erreur de phase égale à (+ π + ε) comme étant égale à (- π + ε) ce qui conduit à une erreur de 2 π, susceptible de faire décrocher la boucle.

Tant que la variation de l'erreur de phase est strictement limitée à π en valeur absolue entre deux instants de mesure le discriminateur fonctionne linéairement. Au delà la boucle est susceptible de décrocher. La limite d'un tel dispositif discriminateur « enrouleur » en erreur de vitesse de phase (ou en vitesse d'erreur de phase) est de π / T en radians par seconde ou π/T en mètres par seconde, λ étant la longueur d'onde et T étant la durée entre deux échantillons de corrélation, ou encore $\pi F_e$, avec $F_e$ la fréquence d'échantillonnage du dispositif qui exécute le discriminateur de phase 106.

Avec un tel dispositif, la tenue à une erreur de vitesse de phase élevée ne peut se faire qu'en augmentant la fréquence d'échantillonnage $F_e$ ce qui entraine une augmentation de la charge de calcul.

Le signal reçu 101 peut être issu d'une voie de données ou d'une voie pilote. Dans le premier cas, le signal 101 est composé d'une porteuse modulée par un code d'étalement et par des données. Dans le second cas, le signal 101 est uniquement composé d'une porteuse et d'un code d'étalement. Le code d'étalement est connu du récepteur, contrairement aux données qui contiennent des informations sur la position des satellites.

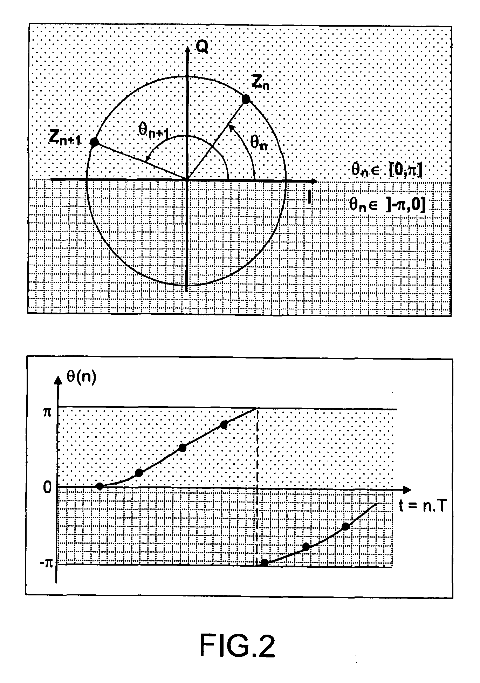

La figure 2 illustre le principe de fonctionnement d'un discriminateur de phase de type arctangente selon l'art antérieur appliqué à une voie pilote.

Sur le haut de la figure sont représentés deux symboles complexes $Z_n$ et $Z_{n+1}$ dans le plan complexe (I,Q) et leurs phases respectives $\theta_n$ et $\theta_{n+1}$. Les deux symboles correspondent à deux échantillons successifs du signal complexe obtenu en sortie des moyens 105 d'intégration cohérente qui permettent le filtrage du signal reçu après la démodulation par la porteuse locale et le code local. L'estimée de l'erreur de phase $\theta_n$ est obtenue en calculant l'arctangente entre la partie réelle et la partie imaginaire du symbole $Z_n$. Sur le bas de la figure 2 est représentée l'évolution de l'estimée de phase $\theta_n$ en fonction du temps t=nT==n/$F_e$. On peut voir que la sortie du discriminateur est limitée entre les valeurs π et -π en radians, ce qui réduit la robustesse de la boucle aux variations de vitesse de phase. Lorsque l'erreur de traînage dépasse π radians, la boucle peut diverger et donc décrocher à cause de la rétro-action en sortie du correcteur qui peut changer de signe.

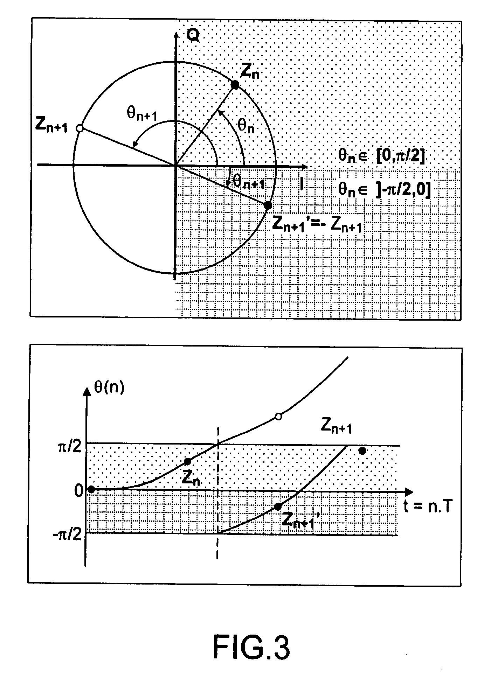

La figure 3 illustre le principe de fonctionnement d'un discriminateur de phase de type arctangente selon l'art antérieur appliqué à une voie de données.

Dans ce deuxième exemple, les symboles $Z_n$, $Z_{n+1}$ obtenus après intégration cohérente 105 sur l'intervalle [nT, (n+1) T] coïncident avec des données binaires [-1, +1] qui modulent le signal. Ces données ne sont pas connues du récepteur, ainsi un changement de signe des données à l'instant (n+1)T se traduira par un changement de signe entre $Z_n$ et $Z_{n+1}$ qu'il ne faut pas confondre avec une variation de phase. La conséquence est que la sortie du discriminateur est cette fois limitée à l'intervalle ]-π/2, π/2] comme illustré sur le bas de la figure 3.

Le principe du discriminateur de phase « enrouleur » selon l'art antérieur consiste à utiliser l'erreur de phase mesurée $\theta_n$ comme référence pour lever l'ambiguïté de l'erreur de phase $\theta_{n+1}$ et supprimer les limitations du discriminateur de type arctangente.

On a $\theta_{n+1} = \theta_n + \Delta\theta_{n+1}$ avec $\Delta\theta_{n+1}$ = arctangente( $I_{n+1}$', $Q_{n+1}$') ∈ ]-π, π] et $Z'_{n+1} = I_{n+1}'+ j Q_{n+1}' = Z_{n+1}. Z_n$ * avec $Z_{n+1}$ = ( $I_{n+1}$ + j $Q_{n+1}$) ,$Z_n$ = ( $I_n$ + j $Q_n$) et $Z_n$ * = ($I_n$ - j Qn ) la valeur conjuguée de $Z_n$.

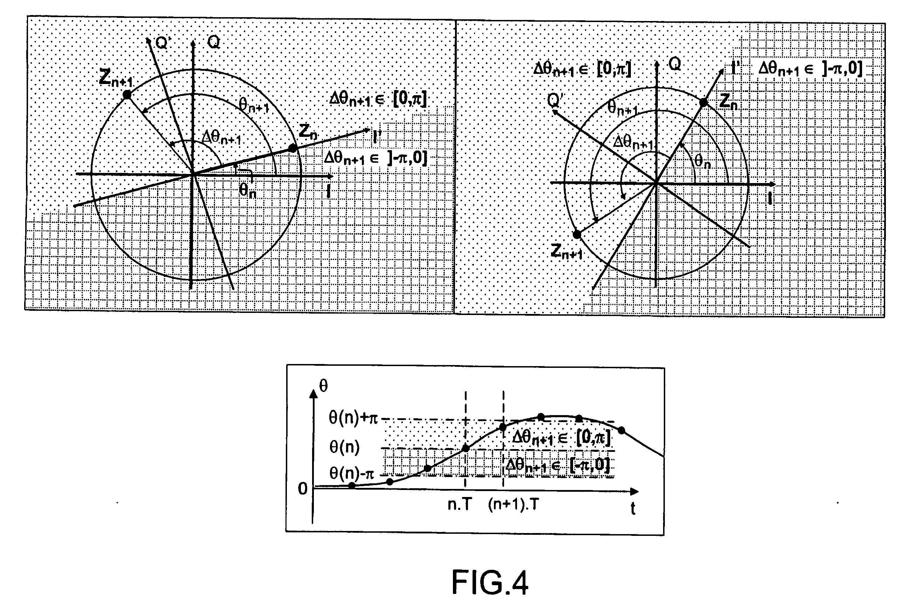

La figure 4 illustre deux exemples pour lesquels le discriminateur de phase « enrouleur » selon l'art antérieur, appliqué à une voie pilote, fonctionne sans décrochage. Dans ces deux exemples, le saut de phase $\Delta\theta_{n+1}$ entre deux symboles consécutifs est inférieur à π en valeur absolue.

L'évolution de la phase $\theta_n$ en fonction du temps est continue et n'engendre aucun décrochage.

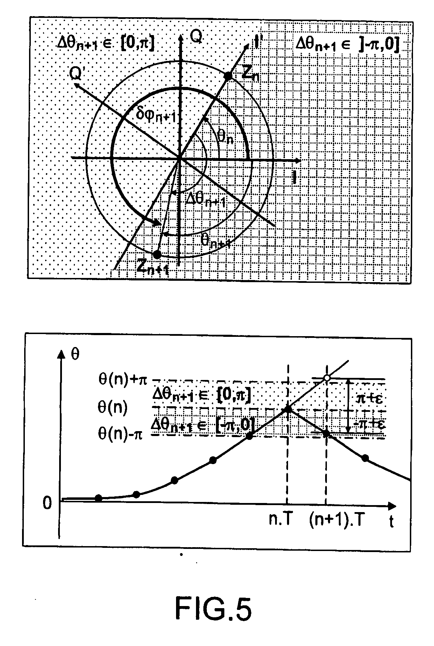

La figure 5 présente un exemple pour lequel le saut de phase entre les deux symboles consécutifs $Z_n$ et $Z_{n+1}$

est supérieur à π en valeur absolue. Dans ce cas, et comme illustré sur la partie basse de la figure 5, la sortie du discriminateur de phase n'est plus limitée en elle-même. Par contre, une limite persiste sur la variation de l'erreur de phase $\Delta\varphi_n$ entre deux mesures. Tant que cette variation reste inférieure en valeur absolue à π alors on reste dans un fonctionnement linéaire tel qu'illustré sur la partie basse de la figure 4 et la boucle de phase ne décroche pas. Par contre si cette variation dépasse en valeur absolue π alors $\theta_{n+1}$ ne reflète plus l'erreur de phase réelle $\Delta\varphi_{n+1} = \varphi_{locale}((n+1).T)$ - $\varphi_{reçue}((n+1).T)$ et la boucle de phase peut décrocher.

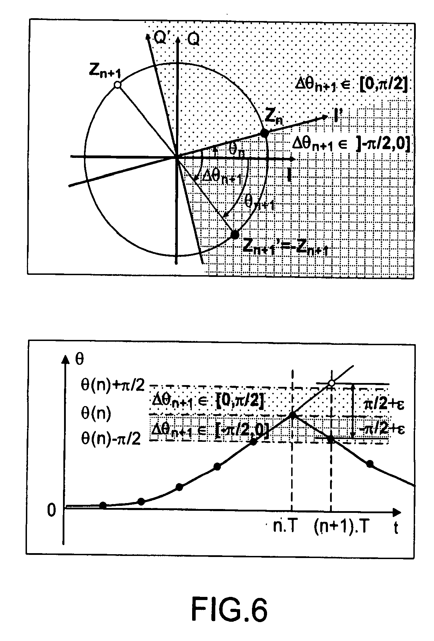

La figure 6 illustre le fonctionnement du discriminateur de phase « enrouleur » appliqué à une voie de données pour laquelle la limitation de saut de phase est cette fois égale à π/2 en valeur absolue. A cause de l'ambiguïté sur le signe de $Z_{n+1}$ due à la modulation par les données on se ramène au demi plan de droite limité par la perpendiculaire à l'axe I' qui contient le symbole $Z_n$. Cela revient à limiter $\Delta\theta_{n+1}$ dans l'intervalle ]-π/2, π/2], ce qui réduit par deux la limite de tolérance en erreur de fréquence Doppler. On a $\theta_{n+1} = \theta_n + \Delta\theta_{n+1}$, $\Delta\theta_{n+1}$ = arctangente( $Q_{n+1}$' /$I_{n+1}$') ∈ ]-π/2, π/2] avec $I_{n+1}$'+j $Q_{n+1}$'= $Z_{n+1}.Z_n^*$, $Z_{n+1}$ = ( $I_{n+1}$ + j $Q_{n+1}$ ), Zn = ( $I_n$ + j $Q_n$) et Zn* = ( $I_n$ - j $Q_n$ ) la valeur conjuguée de $Z_n$.

Le symbole $Z_{n+1}$ est estimé par un tel discriminateur comme étant le symbole $Z'_{n+1}$ = - $Z_{n+1}$ dont l'erreur de phase $\Delta\theta_{n+1}$ qui le sépare du symbole précédent $Z_n$ est inférieure en valeur absolue à π/2.

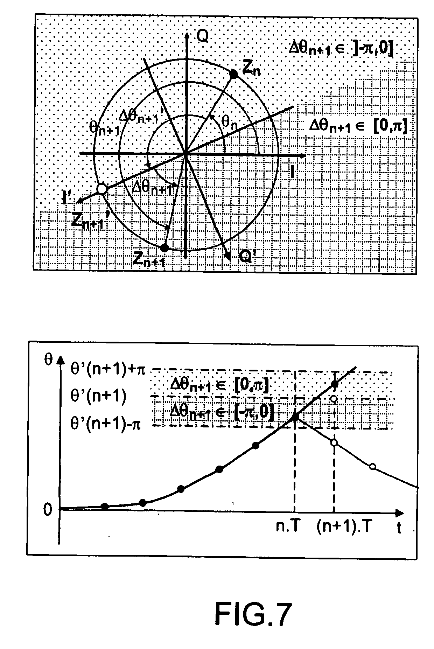

La figure 7 illustre le principe d'un discriminateur de phase selon l'invention.

Afin de supprimer la limitation sur la variation d'erreur de phase inhérente aux discriminateurs de phase connus, la présente invention se base sur l'ajout d'un discriminateur de fréquence permettant de mesurer, en amont du discriminateur de phase, la vitesse de l'erreur de phase ou erreur de fréquence Doppler.

Le principe de l'invention peut être explicité à l'aide des relations suivantes et en concordance avec l'exemple de la figure 7. Deux symboles $Z_n$ et $Z_{n+1}$ consécutifs sont représentés dans le plan complexe (I,Q). Le saut de phase entre ces deux symboles est supérieur à π ce qui correspond à un cas de figure pour lequel les discriminateurs de phase connus ne permettent pas d'assurer une convergence correcte de la boucle de phase.

L'invention consiste à utiliser un symbole intermédiaire $Z'_{n+1}$ = expj( $\Delta\theta_{n+1}$' ). $Z_n$ construit grâce à un discriminateur de fréquence qui permet de mesurer l'erreur de fréquence Doppler $\partial\Delta\varphi/\partial t$ ou erreur de la fréquence de la porteuse locale par rapport à la fréquence de la porteuse reçue. L'erreur de phase $\Delta\theta_{n+1}$' est obtenue à partir de la relation suivante:

$$\Delta\theta_{n+1}' = \mathrm{Discri_{Fréquence}}(n+1).\ 2\pi\ .\ T = \mathrm{Discri_{Fréquence}}(n+1)\ .$$

où $\mathrm{Discri_{Fréquence}}(n+1)$ est une estimation de l'erreur de fréquence Doppler (ou variation de l'erreur de phase) moyenne entre les instants nT et (n+1)T.

L'erreur de phase entre les deux symboles consécutifs peut ainsi être décomposée en une première partie $\Delta\theta_{n+1}$' prévisible grâce à l'estimation de l'erreur de fréquence Doppler et une seconde partie $\Delta\theta_{n+1}$ qui correspond à l'erreur de phase non prévisible. Cela se traduit par les relations suivantes :

$$\theta_{n+1} = \theta_n + \Delta\theta_{n+1}' + \Delta\theta_{n+1}\ (1)$$

avec $\Delta\theta_{n+1}$ = arctangente( $I'_{n+1}$, $Q'_{n+1}$) ∈ ]-π, π]

$$\mathrm{et}\ I_{n+1}'+ j\ Q_{n+1}' =\ Z_{n+1}\ .\ Z_{n+1}'^{*} \qquad (2)$$

L'utilisation d'un discriminateur de fréquence permet de pré corriger le signal afin de ramener l'erreur de phase résiduelle $\Delta\theta_{n+1}$ dans un intervalle ]-π, π] compatible du fonctionnement d'un discriminateur de phase « enrouleur ».

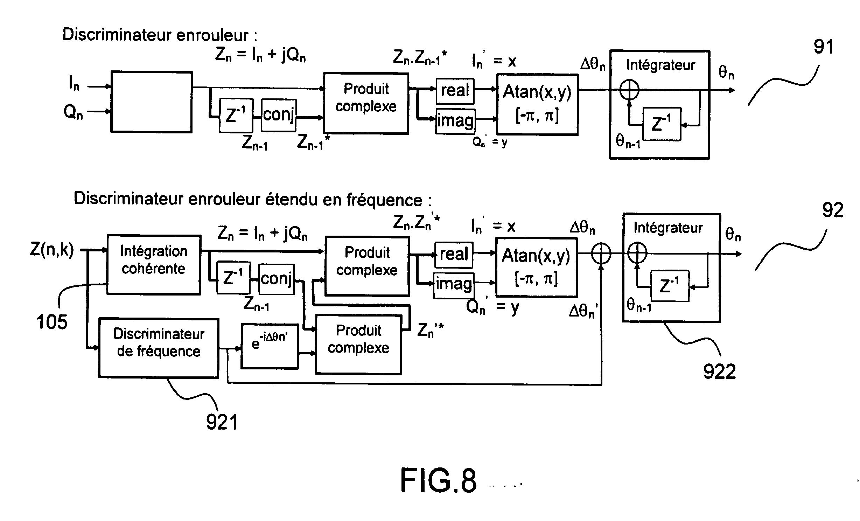

La figure 8 schématise à des fins comparatives un synoptique d'un discriminateur de phase 91 « enrouleur » et un synoptique d'un discriminateur de phase 92 selon l'invention. Ce dernier utilise un discriminateur de fréquence 921 appliqué au signal complexe Z(n,k) reçu avant intégration cohérente à une fréquence d'échantillonnage plus élevée. Le fait d'appliquer le discriminateur de fréquence sur le signal d'entrée des moyens 105 d'intégration cohérente permet d'estimer une fréquence Doppler plus élevée que s'il était appliqué sur le signal de sortie desdits moyens 105 qui présentent une fréquence d'échantillonnage basse due au sous-échantillonnage effectué par les moyens d'intégration cohérente 105. Les moyens 105 peuvent également être séparés en deux étages successifs comme cela sera explicité plus loin dans la description. Un premier étage effectue une intégration cohérente sur une durée $T_0$ par exemple une durée de 1 ms, dont le résultat est utilisé par le discriminateur de fréquence 921 puis un second étage finalise l'intégration cohérente sur une durée $T_1$, par exemple une durée de 20 ms qui correspond à la période d'échantillonnage du logiciel de traitement de signal qui exécute le discriminateur de phase selon l'invention.

Le discriminateur de fréquence 921 produit en sortie une estimée de variation d'erreur de phase prévisible $\Delta'\theta_n$ qui est exploitée conformément aux relations (1) et (2) pour produire les signaux I'$_n$ et Q'$_n$ à partir desquels est calculée la variation d'erreur de phase non prévisible $\Delta\theta_n$. Cette dernière est ajoutée à la variation derreur de phase prévisible $\Delta'\theta_n$ délivrée en sortie du discriminateur de fréquence 921 afin de produire une estimée de variation d'erreur de phase globale précise qui est ensuite produite en entrée d'un intégrateur 922.

Le principe utilisé pour la construction du discriminateur de fréquence selon l'invention est explicité à présent.

Les moyens 105 d'intégration cohérente réalisent notamment une intégration cohérente du signal reçu démodulé sur un intervalle de temps de durée $T_1$. Cet intervalle est découpé en un nombre M de sous-intervalles d'intégration élémentaire de durée $T_0$ Les moyens d'intégration 105 fournissent au discriminateur de phase selon l'invention les résultats des intégrations cohérentes sur une durée $T_0$. L'intégration finale sur la durée $T_1$ est effectuée par la partie logicielle du système de démodulation décrit à la figure 1. En parallèle deux filtres gauche et droite qui réalisent deux hypothèses d'erreur de fréquence Doppler symétriques sont appliqués aux résultats des intégrations cohérentes sur une durée $T_0$ pour construire un discriminateur de fréquence permettant d'extrapoler la variation d'erreur de phase.

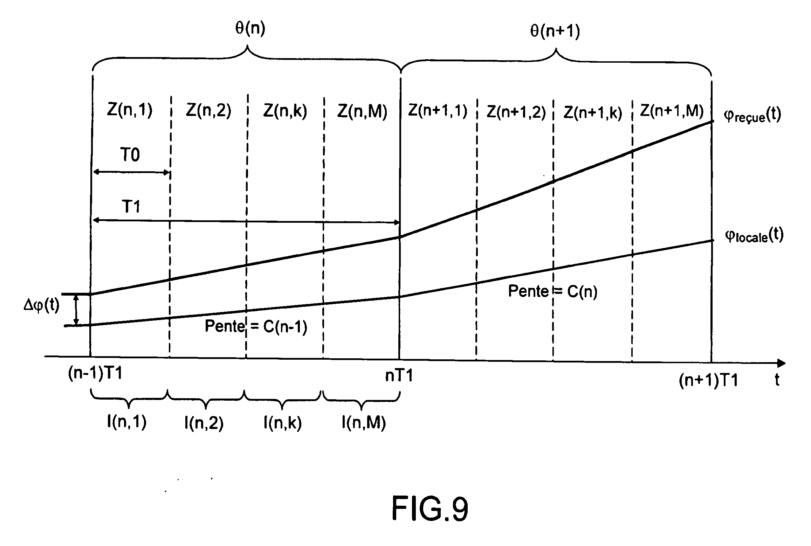

La figure 9 schématise l'évolution de la phase du signal reçu $\varphi_{reçue}(t)$ d'une part et de la phase locale $\varphi_{locale}(t)$ d'autre part. $F_e=1/T_1$ est la fréquence d'échantillonnage, ou de traitement, du dispositif discriminateur de phase selon l'invention. Le symbole Z(n) de phase $\theta(n)$ est étalé sur tout l'intervalle de durée $T_1$. Sa phase $\theta(n)$ correspond à la phase moyenne sur cet intervalle de temps. L'intervalle [(n-1)$T_1$ n$T_1$] est découpé en un nombre M de sous-intervalles I(n,k) de durée $T_0$ pour lesquels un symbole Z(n,k) est produit par les moyens d'intégration 105 qui réalisent ainsi une intégration par morceaux.

Une première hypothèse d'erreur Doppler correspondant à la fréquence $F_0 = F_e/2 = 1/(2T_1)$ est réalisée à partir des symboles Z(n,k):

$$Z_{+1}(n) = \sum_{k=0}^{M-1} Z(n,k)e^{+j\pi\frac{k}{M}}$$

Une seconde hypothèse d'erreur Doppler correspondant à la fréquence -$F_0$ est également réalisée :

$$Z_{-1}(n) = \sum_{k=0}^{M-1} Z(n,k)e^{-j\pi\frac{k}{M}}$$

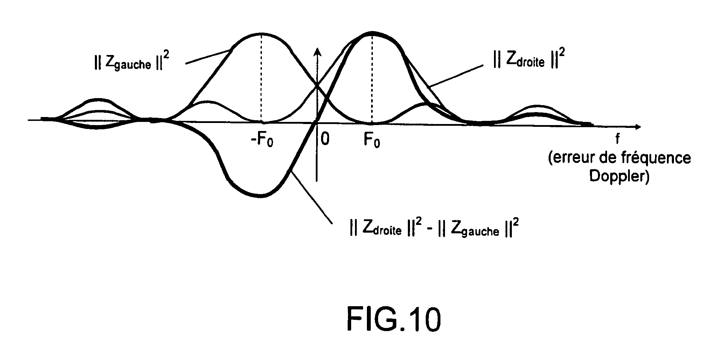

Le calcul de la quantité $\|Z_{+1}(n)\|^2$-$\|Z_{-1}(n)\|^2$ permet d'obtenir une estimée d'erreur de fréquence proportionnelle à l'erreur de fréquence Doppler si celle-ci reste limitée à la zone linéaire entre -$F_0$ et +$F_0$ tel que cela est illustré sur la figure 10.

Le discriminateur de fréquence selon l'invention produit en sortie l'estimée suivante exprimée en Hertz :

$$Discri_{Fréquence}(n) = \frac{\left\{\|Z_{+1}(n)\|^2 - \|Z_{-1}(n)\|^2\right\}}{(32CT_1/\pi^2)}$$

avec C la puissance estimée du signal reçu par exemple par l'intermédiaire de la relation suivante $C = \|Z(n)\|^2$.

Dans une variante de réalisation de l'invention, une troisième hypothèse d'erreur Doppler, dite centrée, est exploitée. Cette hypothèse est déterminée par la relation suivante :

$$Z_0(n) = \sum_{k=0}^{M-1} Z(n,k) = Z(n)$$

Le discriminateur de fréquence selon l'invention produit dans ce cas en sortie l'estimée suivante exprimée en

Hertz :

$$Discri_{Fréquence}(n) = \frac{\mathrm{Re}[(Z_{+1}(n) - Z_{-1}(n)).Z_0(n)^*]}{(16CT_1/\pi^2)}$$

avec $Z_0(n)^*$, le complexe conjugué de $Z_0(n)$.

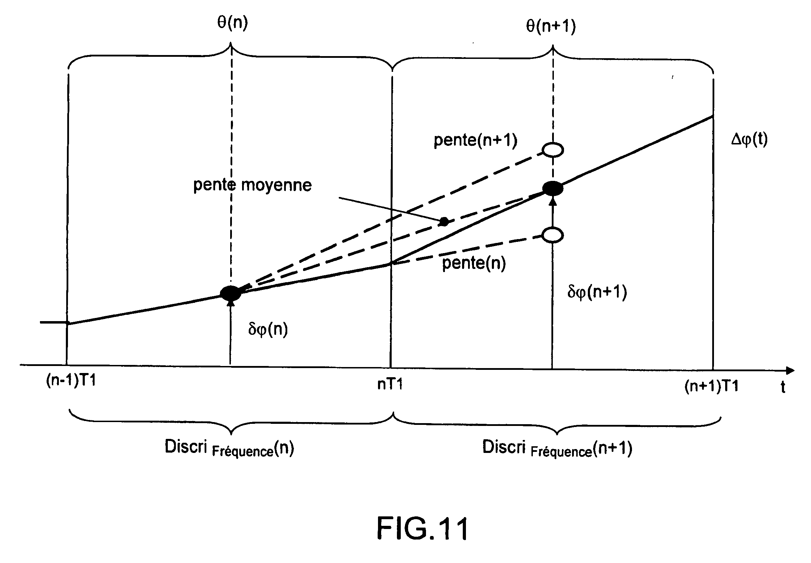

La figure 11 illustre une variante de réalisation du discriminateur de fréquence selon l'invention. A l'instant $(n+1)T_1$, les estimées $Discri_{fréquence}(n)$ et $Discri_{fréquence}(n+1)$ des variations de phase aux instants n et n+1 sont disponibles. $Discri_{fréquence}(n)$ est représentatif de la variation de l'erreur de phase sur l'intervalle de temps $[(n-9)T_1 \ nT_1]$ et $Discri_{fréquence}(n+1)$ est représentatif de la variation de l'erreur de phase sur l'intervalle de temps $[nT_1 \ (n+1)T_1]$. Ces deux estimées sont représentées sur la figure 11 respectivement par les pentes des droites que suivent l'erreur de phase $\delta\varphi$ en fonction du temps sur chaque intervalle de durée $T_1$. Afin d'améliorer la précision du discriminateur de fréquence, la moyenne de deux estimations successives est utilisée afin de produire en sortie le résultat suivant :

$$\frac{Discri_{Fréquence}(n) + Discri_{Fréquence}(n+1)}{2}$$

Dans une autre variante de réalisation de l'invention, la sortie du discriminateur de fréquence calculée à l'instant $(n-1)T_1$ est utilisée pour corriger les hypothèses d'erreur Doppler gauche et droite effectuées initialement aux fréquences $F_0$ et -$F_0$. Les relations suivantes sont utilisées :

$$Z_{+1}(n) = \sum_{k=0}^{M-1} Z(n,k) e^{+j\pi\frac{k}{M}} e^{-j2\pi.Discri_{Fréquence}(n-1)}$$

$$Z_{-1}(n) = \sum_{k=0}^{M-1} Z(n,k) e^{-j\pi\frac{k}{M}} e^{-j2\pi.Discri_{Fréquence}(n-1)}$$

$$Discri_{Fréquence}(n) = \frac{\mathrm{Re}[(Z_{+1}(n) - Z_{-1}(n)).Z_0(n)^*]}{(16CT_1/\pi^2)}$$

$$+ Discri_{Fréquence}(n-1)$$

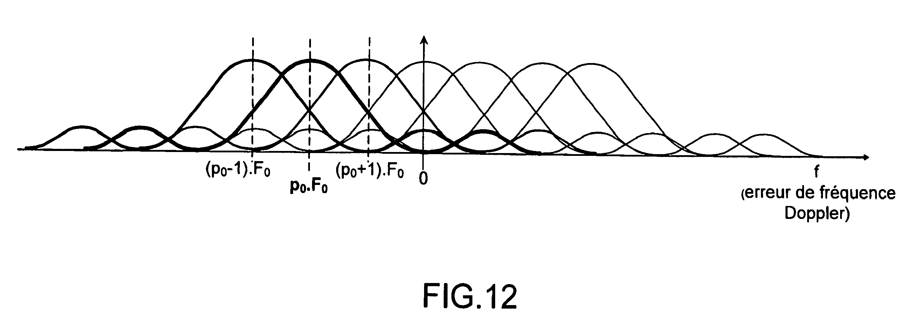

Dans une autre variante de réalisation de l'invention, tel qu'illustré à la figure 12, afin d'élargir encore le domaine de fonctionnement en erreur de trainage en vitesse du discriminateur de phase, on effectue un nombre S d'hypothèses d'erreur Doppler aux valeurs de fréquence suivantes : -S $F_0$,..., - 2 $F_0$,- Fo, 0, $F_0$, 2$F_0$, ... S$F_0$.

Ces N hypothèses s'écrivent de façon générale à l'aide de la relation suivante :

$$Z_p(n) = \sum_{k=0}^{M-1} Z(n,k) e^{-j\pi.p\frac{k}{M}}$$

pour p variant de -S à S

L'indice $p_0$ correspondant à la valeur $\|Z_{p0}(n)\|^2$ maximale parmi toutes les hypothèses calculées est retenu afin de construire le discriminateur de fréquence autour de ce maximum à l'aide d'une des deux relations suivantes :

$$Discri_{Fréquence}(n) = \frac{\left\{ \left\| Z_{p_0+1}(n) \right\|^2 - \left\| Z_{p_0-1}(n) \right\|^2 \right\}}{(32CT_1 / \pi^2)} + p_0 F_0$$

$$Discri_{Fréquence}(n) = \frac{\text{Re}[(Z_{p_0+1}(n) - Z_{p_0-1}(n)).Z_{p_0}(n)^*]}{(16CT_1 / \pi^2)} + p_0 F_0$$

Dans une autre variante de réalisation de l'invention, l'utilisation du discriminateur de fréquence est conditionnée au rapport signal à bruit estimé. Le discriminateur de phase étendu en fréquence selon l'invention permet d'augmenter sensiblement la zone de fonctionnement en phase de la boucle à verrouillage de phase. Cependant l'utilisation du discriminateur de fréquence est susceptible de rendre la boucle de phase moins robuste au bruit thermique ou au bruit dû aux interférences. Pour pallier cet inconvénient, la sortie du discriminateur de fréquence est forcée à zéro lorsque le rapport signal à bruit estimé devient inférieur à un seuil donné, par exemple un seuil de 10 dB.

L'estimation du rapport signal à bruit est effectuée à partir des hypothèses d'erreur Doppler préalablement calculées à partir d'une des relations suivantes :

$$\hat{RSB} = \frac{\left\| Z_{p_0}(n) \right\|^2}{\sigma_b^2} \; ou \; \hat{RSB} = \frac{\left\| Z_0(n) \right\|^2}{\sigma_b^2}$$

Où $\sigma_b^2$ est une estimation de bruit réalisée par le récepteur sur l'intervalle d'intégration de durée $T_1$, par exemple à l'aide de la relation

$$\sigma_b^2 = \sum_{k=0}^{M-1} \left\| Z_b(n,k) \right\|^2 \; ,$$

avec $Z_b(n,k)$ sont des échantillons de bruit calculés, sur l'intervalle de temps de durée $T_1$, sur une voie de démodulation dédiée ne contenant que du bruit en sortie.

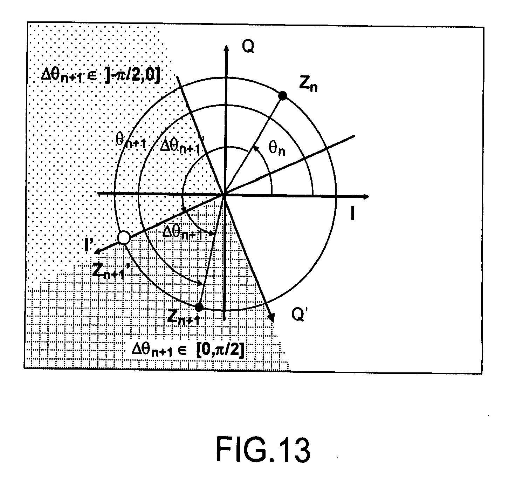

La figure 13 illustre le fonctionnement du discriminateur de phase selon l'invention appliqué à une voie de données. Le principe utilisé est identique, à la différence près que l'erreur de phase $\Delta\theta_{n+1}$ présente une ambigüité de $\pi/2$ au lieu de $\pi$ dans le cas d'une voie pilote. La tolérance à la dynamique en erreur de phase est donc moindre et la vitesse d'erreur de phase maximum pour laquelle le discriminateur de phase selon l'invention fonctionnera correctement est sensiblement deux fois moins importante que dans le cas d'une voie pilote.

Dans une variante de réalisation de l'invention, les seconds moyens d'intégration cohérente 105 sont supprimés et le dispositif discriminateur de fréquence 921 réalise une estimation de l'erreur de fréquence directement à partir du signal reçu à la fréquence $F_e$. L'estimée d'erreur de fréquence peut également être réalisée par un dispositif externe à l'invention et est dans ce cas fournie comme paramètre d'entrée au discriminateur de phase selon l'invention.

La présente invention s'applique à tous les récepteurs de radionavigation, et plus largement à tout récepteur incluant des moyens de démodulation d'une porteuse dont on souhaite estimer précisément la phase ou l'erreur de phase. Elle permet soit d'augmenter la tenue à la dynamique en phase en limitant la charge de calcul, soit de réduire la fréquence d'échantillonnage de la boucle de phase pour des performances équivalentes.

Dans le cas d'un récepteur adapté à démoduler un signal dont le spectre n'a pas été étalé, les moyens 105 d'intégration cohérente se confondent avec des moyens de filtrage et de sous échantillonnage. Dans le cas d'un récepteur de radionavigation, les moyens 105 d'intégration cohérente réalisent implicitement un sous échantillonnage du signal.

**Revendications**

1. Dispositif discriminateur (106) de phase recevant en entrée un signal complexe dont l'argument représente une erreur de phase $\Delta\varphi$ et produisant en sortie une estimée $\theta_{n+1}$ de l'erreur de phase $\Delta\varphi$ pour chaque échantillon de signal $Z_{n+1}$ reçu, **caractérisé en ce qu'**il comporte des moyens de calculs adaptés à déterminer l'estimée de phase obtenue à un instant $(N+1)T_1$ à l'aide des relations suivantes:

$$\theta_{n+1} = \theta_n + \Delta\theta_{n+1} + \Delta\theta'_{n+1}$$

$$\Delta\theta'_{n+1} = Discri_{Fréquence}(n+1).2\pi.T_1$$

$$\Delta\theta_{n+1} = \arctan(I'_{n+1}, Q'_{n+1})$$

$$I'_{n+1} + jQ'_{n+1} = Z_{n+1}.Z'^*_{n+1}$$

$$Z'_{n+1} = \exp(j\Delta\theta'_{n+1}).Z_n$$

où $T_1$ est l'intervalle de temps entre deux échantillons $Z_n$ et $Z_{n+1}$ consécutivement reçus, $Discri_{frequence}(n+1)$ est une estimée de l'erreur de fréquence $\partial\Delta\varphi/\partial$at dudit signal complexe produite par un discriminateur de fréquence (921) que comporte ledit dispositif (106), et $Z'^*_{n+1}$ est le complexe conjugué de $Z'_{n+1}$.

2. Dispositif discriminateur (106) de phase selon la revendication 1 **caractérisé en ce qu'**il comporte en outre des premiers moyens d'intégration cohérente (105) dudit signal produisant à partir d'un nombre M d'échantillons complexes $Z_{n,k}$ de signal à la fréquence $F'_e = 1/T_0$ un échantillon complexe $Z_n$ à la fréquence $F_e = 1/T_1$, chaque intervalle de temps de durée $T_1$ étant subdivisé en un nombre M d'intervalles de temps de durée $T_o$, ledit discriminateur de fréquence (921 déterminant l'estimée d'erreur de fréquence $Discri_{fréquence}(n)$ à partir desdits échantillons $Z_{n,k}$.

3. Dispositif discriminateur (106) de phase selon la revendication 2 **caractérisé en ce que** ledit discriminateur de fréquence (921) comporte au moins des premiers moyens de calcul d'au moins deux hypothèses d'erreur de fréquence selon les fréquences $-F_0$ et $+F_0$ avec $F_0 = F_e/2$ :

$$Z_{+1}(n) = \sum_{k=0}^{M-1} Z(n,k)e^{+j\pi\frac{k}{M}}$$

$$Z_{-1}(n) = \sum_{k=0}^{M-1} Z(n,k)e^{-j\pi\frac{k}{M}},$$

et des seconds moyens de calcul de l'estimée d'erreur de fréquence à l'aide d'une des deux relations suivantes :

$$Discri_{Fréquence}(n) = \frac{\left\{\left\|Z_{+1}(n)\right\|^2 - \left\|Z_{-1}(n)\right\|^2\right\}}{(32CT_1 / \pi^2)}$$

ou

$$Discri_{Fréquence}(n) = \frac{\mathrm{Re}[(Z_{+1}(n) - Z_{-1}(n)).Z_0(n)^*]}{(16CT_1 / \pi^2)}$$

avec C la puissance estimée du signal reçu et $Z_0(n) = Z_n$

4. Dispositif discriminateur (106) de phase selon la revendication 3 **caractérisé en ce que** l'estimée d'erreur de fréquence est remplacée par la moyenne des estimées d'erreur de fréquence obtenues aux instants n et n+1.

5. Dispositif discriminateur (106) de phase selon la revendication 3 **caractérisé en ce que** lesdites hypothèses d'erreur de fréquence sont corrigées de l'estimée d'erreur de fréquence obtenue à l'instant précédent :

$$Z_{+1}(n) = \sum_{k=0}^{M-1} Z(n,k)e^{+j\pi\frac{k}{M}}e^{-j2\pi.Discri_{Fréquence}(n-1)}$$

$$Z_{-1}(n) = \sum_{k=0}^{M-1} Z(n,k)e^{-j\pi\frac{k}{M}}e^{-j2\pi.Discri_{Fréquence}(n-1)}$$

et que l'estimée d'erreur de fréquence déterminée à l'instant n-1 est ajoutée à celle obtenue à l'instant n.

6. Dispositif discriminateur (106) de phase selon la revendication 3 **caractérisé en ce que** lesdits premiers moyens de calcul réalisent un nombre 2S d'hypothèses d'erreur de fréquence aux valeurs de fréquence allant de $-SF_0$ à $+SF_0$ par pas de $F_0$ selon les relations

$$Z_{+p}(n) = \sum_{k=0}^{M-1} Z(n,k)e^{+j\pi p\frac{k}{M}} \quad \text{et} \quad Z_{-p}(n) = \sum_{k=0}^{M-1} Z(n,k)e^{-j\pi p\frac{k}{M}} \,, \quad \text{que} \qquad \text{ledit}$$

discriminateur de fréquence (921) comporte en outre des moyens de détermination de l'indice $p_0$ associé à la valeur $\|Z_{p0}(n)\|^2$ maximum dans l'ensemble [-(S-1)...,-2,-1,0,1,2,...(S-1)], avec $Z_0(n)=Z_n$ et que l'estimée d'erreur de fréquence est déterminée à l'aide d'une des deux relations suivantes :

$$Discri_{Fréquence}(n) = \frac{\left\{\left\|Z_{p_0+1}(n)\right\|^2 - \left\|Z_{p_0-1}(n)\right\|^2\right\}}{(32CT_1 / \pi^2)} + p_0 F_0$$

ou

$$Discri_{Fréquence}(n) = \frac{\text{Re}[(Z_{p_0+1}(n) - Z_{p_0-1}(n)).Z_{p_0}(n)^*]}{(16CT_1/\pi^2)} + p_0 F_0$$

**7.** Dispositif discriminateur (106) de phase selon l'une des revendications 2 à 6 **caractérisé en ce qu'**il comporte en outre des moyens d'estimation du rapport signal sur bruit $\hat{RSB}$, des moyens de comparaison dudit rapport signal sur bruit avec un seuil prédéterminé en fonction d'un compromis entre l'étendue de la dynamique en fréquence dudit dispositif et sa résistance au bruit et des moyens de désactivation et d'activation dudit discriminateur de fréquence (921) en fonction du résultat de la comparaison.

**8.** Dispositif discriminateur (106) de phase selon la revendication 7 **caractérisé en ce qu'**il comporte en outre des moyens d'estimation de la puissance de bruit $\sigma_b^2$, par exemple à l'aide de la relation $\sigma_b^2 = \sum_{k=0}^{M-1} \left\| Z_b(n,k) \right\|^2$ avec $Z_b(n,k)$ des échantillons de bruit mesurés et que le rapport signal sur bruit est estimé à l'aide d'une des relations suivantes:

$$\hat{RSB} = \frac{\left\| Z_{p_0}(n) \right\|^2}{\sigma_b^2} \quad ou \quad \hat{RSB} = \frac{\left\| Z_0(n) \right\|^2}{\sigma_b^2}$$

**9.** Dispositif (10) de réception de signaux de radionavigation par satellite recevant un signal (101) continu modulé par une porteuse, de phase $\varphi_{reçue}$, comprenant au moins des moyens permettant de générer une porteuse locale, de phase $\varphi_{locale}$, et des moyens de démodulation et de filtrage dudit signal (101), **caractérisé en ce qu'**il comporte en outre des seconds moyens (105) d'intégration cohérente dudit signal qui délivrent en sortie un nombre M d'échantillons $Z_{n,k}$ à une fréquence d'échantillonnage $F'_e$ et une boucle à verrouillage de phase comprenant au moins un dispositif discriminateur (106) de phase selon l'une des revendications précédentes qui reçoit en entrée un signal complexe dont l'argument représente l'erreur de phase $\Delta\varphi = \varphi_{locale} - \varphi_{reçue}$ et qui permet d'asservir la phase $\varphi_{locale}$ de la porteuse locale sur celle $\varphi_{reçue}$ de la porteuse reçue.

**Claims**

**1.** A phase discriminator device (106) receiving as input a complex signal, the argument of which represents a phase error $\Delta\varphi$, and producing as output an estimate $\theta_{n+1}$ of the phase error $\Delta\varphi$ for each received signal sample $Z_{n+1}$, **characterised in that** it comprises computing means designed to determine the phase estimate obtained at an instant $(N+1)T_1$ using the following relations:

$$\theta_{n+1} = \theta_n + \Delta\theta_{n+1} + \Delta\theta'_{n+1}$$

$$\Delta\theta'_{n+1} = Discri_{frequency}(n+1) \cdot 2\pi \cdot T_1$$

$$\Delta\theta_{n+1} = \arctan(I'_{n+1}, Q'_{n+1})$$

$$I'_{n+1} + jQ'_{n+1} = Z_{n+1} \cdot Z'^*_{n+1}$$

$$Z'_{n+1} = \exp(j\Delta\theta'_{n+1}) \cdot Z_n$$

where $T_1$ is the time interval between two consecutively received samples $Z_n$ and $Z_{n+1}$, $Discri_{frequency}(n+1)$ is an estimate of the frequency error $\partial\Delta\varphi/\partial t$ of said complex signal produced by a frequency discriminator (921) that comprises said device (106), and $Z'^*_{n+1}$ is the complex conjugate of $Z'_{n+1}$.

2. The phase discriminator device (106) according to claim 1, **characterised in that** it further comprises first means for coherent integration (105) of said signal producing, on the basis of a number M of complex samples $Z_{n,k}$ of signals at the frequency $F'_e=1/T_0$, a complex sample $Z_n$ at the frequency $F_e=1/T_1$, each time interval of duration $T_1$ being subdivided into a number M of time intervals of duration To, said frequency discriminator (921) determining the frequency error estimate $Discri_{frequency}(n)$ on the basis of said samples Zn,k.

3. The phase discriminator device (106) according to claim 2, **characterised in that** said frequency discriminator (921) comprises at least first means for computing at least two frequency error hypotheses at the frequencies $-F_0$ and $+F_0$ with $F_0=F_e/2$:

$$Z_{+1}(n) = \sum_{k=0}^{M-1} Z(n,k)e^{+j\pi\frac{k}{M}}$$

$$Z_{-1}(n) = \sum_{k=0}^{M-1} Z(n,k)e^{-j\pi\frac{k}{M}},$$

and second means for computing the frequency error estimate using one of the following two relations:

$$Discri_{Frequency}(n) = \frac{\left\{\|Z_{+1}(n)\|^2 - \|Z_{-1}(n)\|^2\right\}}{(32CT_1/\pi^2)}$$

or

$$Discri_{Frequency}(n) = \frac{\text{Re}[(Z_{+1}(n) - Z_{-1}(n)).Z_0(n)^*]}{(16CT_1/\pi^2)}$$

with C being the estimated power of the received signal and $Z_0(n)=Z_n$.

4. The phase discriminator device (106) according to claim 3, **characterised in that** the frequency error estimate is replaced by the mean of the frequency error estimates obtained at instants n and n+1.

5. The phase discriminator device (106) according to claim 3, **characterised in that** said frequency error hypotheses are corrected from the frequency error estimate obtained at the preceding instant:

$$\overline{Z}_{+1}(n) = \sum_{k=0}^{M-1} Z(n,k)e^{+j\pi\frac{k}{M}}e^{-j2\pi.Discri_{Frequency}(n-1)}$$

$$Z_{-1}(n) = \sum_{k=0}^{M-1} Z(n,k) e^{-j\pi\frac{k}{M}} e^{-j2\pi.Discri_{Frequency}(n-1)}$$

and that the frequency error estimate determined at the instant n-1 is added to that obtained at the instant n.

6. The phase discriminator device (106) according to claim 3, **characterised in that** said first computing means carry out a number 2S of frequency error hypotheses at frequency values that range from $-SF_0$ to $+SF_0$ in steps of $F_0$ according to the relations $Z_{+p}(n) = \sum_{k=0}^{M-1} Z(n,k) e^{+j\pi p\frac{k}{M}}$ and $Z_{-p}(n) = \sum_{k=0}^{M-1} Z(n,k) e^{-j\pi p\frac{k}{M}}$, discriminator (921) further comprises means for determining the index $p_o$ that is associated with the maximum value $\|Z_{p0}(n)\|^2$ in the set [-(S-1)...,-2,-1,0,1,2,...(S-1)], with $Z_0(n)=Z_n$ and that the frequency error estimate is determined using one of the following two relations:

$$Discri_{Frequency}(n) = \frac{\left\{\left\|Z_{p_0+1}(n)\right\|^2 - \left\|Z_{p_0-1}(n)\right\|^2\right\}}{(32CT_1/\pi^2)} + p_0F_0$$

or

$$Discri_{Frequency}(n) = \frac{\operatorname{Re}[(Z_{p_0+1}(n) - Z_{p_0-1}(n)).Z_{p_0}(n)^*]}{(16CT_1/\pi^2)} + p_0F_0$$

7. The phase discriminator device (106) according to any one of claims 2 to 6, **characterised in that** it further comprises means for estimating the signal to noise ratio $\hat{RSB}$, means for comparing said signal-to-noise ratio with a predetermined threshold as a function of a compromise between the extent of the frequency dynamic of said device and its resistance to noise and means for deactivating and activating said frequency discriminator (921) as a function of the result of the comparison.

8. The phase discriminator device (106) according to claim 7, **characterised in that** it further comprises means for estimating the noise power $\sigma_b^2$, for example, using the $\sigma_b^2 = \sum_{k=0}^{M-1} \|Z_b(n,k)\|^2$ relation with $Z_b(n, k)$ of the measured noise samples, and **in that** the signal to noise ratio is estimated using one of the following relations: $\hat{RSB} = \frac{\|Z_{p_0}(n)\|^2}{\sigma_b^2}$

or $\hat{RSB} = \frac{\|Z_0(n)\|^2}{\sigma_b^2}$.

9. A device (10) for receiving satellite radio navigation signals receiving a continuous signal (101) that is modulated by a carrier, of phase $\varphi_{received}$, comprising at least means for generating a local carrier, of phase $\varphi_{local}$, and means for demodulating and filtering said signal (101), **characterised in that** it further comprises second means (105) for coherent integration of said signal that delivers as output a number M of samples $Z_{n,k}$ at a sampling frequency $F'_e$ and a phase-locked loop comprising at least one phase discriminator device (106) according to any one of the preceding claims that receives as input a complex signal, the argument of which represents the phase error $\Delta\varphi = \varphi_{local} - \varphi_{received}$, and which allows control of the phase $\varphi_{local}$ of the local carrier with that $\varphi_{received}$ of the received carrier.

**Patentansprüche**

1. Vorrichtung zur Phasendiskriminierung (106), die als Eingang ein komplexes Signal empfängt, dessen Argument einen Phasenfehler $\Delta\varphi$ repräsentiert, und die als Ausgang eine Schätzung $\theta_{n+1}$ des Phasenfehlers $\Delta\varphi$ für jede empfangene Signalprobe $Z_{n+1}$ erzeugt, **dadurch gekennzeichnet, dass** sie Rechenmittel zum Ermitteln der zu einem Zeitpunkt $(N+1)T_1$ erhaltenen Phasenschätzung mit Hilfe der folgenden Beziehungen beinhaltet:

$$\theta_{n+1}=\theta_n+\Delta\theta_{n+1}+\Delta\theta'_{n+1}$$

$$\Delta\theta'_{n+1}=\text{Discri}_{Frequenz}(n+1)\cdot 2\pi\cdot T_1$$

$$\Delta\theta_{n+1}=\arctan(I'_{n+1},Q'_{n+1})$$

$$I'_{n+1}+jQ'_{n+1}=Z_{n+1}\cdot Z'^{*}_{n+1}$$

$$Z'_{n+1}=\exp(j\Delta\theta'_{n+1})\cdot Z_n$$

wobei $T_1$ das Zeitintervall zwischen zwei nacheinander empfangenen Proben $Z_n$ und $Z_{n+1}$ ist, $\text{Discri}_{Frequenz}(n+1)$ eine Schätzung des Frequenzfehlers $\partial\Delta\varphi/\partial t$ des komplexen Signals ist, das von einem Frequenzdiskriminator (921) erzeugt wird, der die Vorrichtung (106) umfasst, und $Z'^{*}_{n+1}$ das komplexe Konjugat von $Z'_{n+1}$ ist.

2. Vorrichtung (106) zur Phasendiskriminierung nach Anspruch 1, **dadurch gekennzeichnet, dass** sie ferner erste Mittel für eine kohärente Integration (105) des Signals umfasst, das auf der Basis einer Zahl M von komplexen Proben $Z_{n,k}$ von Signalen mit der Frequenz $F'_e=1/T_0$ eine komplexe Probe $Z_n$ mit der Frequenz $F_e=1/T_1$ erzeugt, wobei jedes Zeitintervall mit der Dauer $T_1$ in eine Zahl M von Zeitintervallen der Dauer To unterteilt wird, wobei der Frequenzdiskriminator (921) die Frequenzfehlerschätzung $\text{Discri}_{Frequenz}(n)$ auf der Basis der Proben $Z_{n,k}$ ermittelt.

3. Vorrichtung (106) zur Phasendiskriminierung nach Anspruch 2, **dadurch gekennzeichnet, dass** der Frequenzdiskriminator (921) wenigstens erste Mittel zum Berechnen von wenigstens zwei Frequenzfehlerhypothesen gemäß den Frequenzen $-F_0$ und $+F_0$ umfasst, wobei $F_0=F_e/2$:

$$Z_{+1}(n) = \sum_{k=0}^{M-1} Z(n,k)e^{+j\pi\frac{k}{M}}$$

$$Z_{-1}(n) = \sum_{k=0}^{M-1} Z(n,k)e^{-j\pi\frac{k}{M}},$$

und zweite Mittel zum Berechnen der Frequenzfehlerschätzung anhand der folgenden zwei Beziehungen umfasst:

$$Discri_{Frequenz}(n) = \frac{\left\{\|Z_{+1}(n)\|^2 - \|Z_{-1}(n)\|^2\right\}}{(32CT_1/\pi^2)},$$

oder

$$Discri_{Frequenz}(n) = \frac{\text{Re}[(Z_{+1}(n) - Z_{-1}(n)).Z_0(n)^*]}{(16CT_1/\pi^2)}$$

wobei C die geschätzte Leistung des empfangenen Signals ist und $Z_0(n)=Z_n$.

**4.** Vorrichtung (106) zur Phasendiskriminierung nach Anspruch 3, **dadurch gekennzeichnet, dass** die Frequenzfehlerschätzung durch das Mittel der zu den Zeitpunkten n und n+1 erhaltenen Frequenzfehlerschätzungen ersetzt wird.

**5.** Vorrichtung (106) zur Phasendiskriminierung nach Anspruch 3, **dadurch gekennzeichnet, dass** die Frequenzfehlerhypothesen von der am vorherigen Zeitpunkt erhaltenen Frequenzfehlerschätzung korrigiert werden:

$$Z_{+1}(n) = \sum_{k=0}^{M-1} Z(n,k)e^{+j\pi\frac{k}{M}}e^{-j2\pi.Discri_{Frequenz}(n-1)}$$

$$Z_{-1}(n) = \sum_{k=0}^{M-1} Z(n,k)e^{-j\pi\frac{k}{M}}e^{-j2\pi.Discri_{Frequenz}(n-1)}$$

und dass die zum Zeitpunkt n-1 ermittelte Frequenzfehlerschätzung zu der zum Zeitpunkt n erhaltenen addiert wird.

**6.** Vorrichtung (106) zur Phasendiskriminierung nach Anspruch 3, **dadurch gekennzeichnet, dass** die genannten ersten Rechenmittel eine Zahl 2S von Frequenzfehlerhypothesen mit Frequenzwerten im Bereich von -SF$_0$ bis +SF$_0$ in Schritten von Fo gemäß den Beziehungen $Z_{+P}(n) = \sum_{k=0}^{M-1} Z(n,k)e^{+j\pi p\frac{k}{M}}$ und $Z_{-P}(n) = \sum_{k=0}^{M-1} Z(n,k)e^{-j\pi p\frac{k}{M}}$ durchführen, dass der Frequenzdiskriminator (921) ferner Mittel zum Ermitteln des Indexes $p_0$ umfasst, der mit dem Maximalwert $\|Z_{po}(n)\|^2$ in dem Satz [-(S-1)...,-2,-1,0,1,2,...(S-1)] assoziiert ist, wobei $Z_0(n)=Z_n$, und dass die Frequenzfehlerschätzung mit Hilfe von einer der folgenden beiden Beziehungen ermittelt wird:

$$Discri_{Frequenz}(n) = \frac{\left\{\|Z_{p_0+1}(n)\|^2 - \|Z_{p_0-1}(n)\|^2\right\}}{(32CT_1/\pi^2)} + p_0F_0$$

*oder*

$$Discri_{Frequenz}(n) = \frac{\text{Re}[(Z_{p_0+1}(n) - Z_{p_0-1}(n)).Z_{p_0}(n)^*]}{(16CT_1/\pi^2)} + p_0F_0$$

**7.** Vorrichtung (106) zur Phasendiskriminierung nach einem der Ansprüche 2 bis 6, **dadurch gekennzeichnet, dass** sie ferner Mittel zum Schätzen des Signal-Rausch-Verhältnisses *RSB*, Mittel zum Vergleichen des Signal-Rausch-Verhältnisses mit einem vorbestimmten Schwellenwert in Abhängigkeit von einem Kompromiss zwischen dem Ausmaß der Frequenzdynamik der Vorrichtung und ihrer Rauschfestigkeit sowie Mittel zum Deaktivieren und Aktivieren des Frequenzdiskriminators (921) in Abhängigkeit vom Ergebnis des Vergleichs umfasst.

**8.** Vorrichtung (106) zur Phasendiskriminierung nach Anspruch 7, **dadurch gekennzeichnet, dass** sie ferner Mittel zum Schätzen der Rauschleistung $\sigma_b^2$, zum Beispiel mit Hilfe der Beziehung $\sigma_b^2 = \sum_{k=0}^{M-1}\|Z_b(n,k)\|^2$ mit $Z_b(n, k)$ der gemessenen Rauschproben umfasst, und dass das Signal-Rausch-Verhältnis mit einer der folgenden Beziehungen geschätzt wird: $\hat{RSB} = \dfrac{\left\| \overline{Z_{p_0}(n)} \right\|^2}{\sigma_b^2}$ oder $\hat{RSB} = \dfrac{\left\| Z_0(n) \right\|^2}{\sigma_b^2}$ .

9.  Vorrichtung (10) zum Empfangen von Funknavigationssignalen per Satellit, der ein von einem Träger moduliertes kontinuierliches Signal (101) mit Phase $\varphi_{empfangen}$ empfängt, die wenigstens Mittel, mit denen ein örtlicher Träger mit Phase $\varphi_{lokal}$ erzeugt werden kann, und Mittel zum Demodulieren und Filtern des Signals (101) umfasst, **dadurch gekennzeichnet, dass** sie ferner zweite Mittel (105) für eine kohärente Integration des Signals, das als Ausgang eine Zahl M von Proben $Z_{n,k}$ mit einer Abtastfrequenz $F'_e$ liefert, und einen Phasenregelkreis umfasst, der wenigstens eine Vorrichtung (106) zur Phasendiskriminierung nach einem der vorherigen Ansprüche umfasst, die als Eingang ein komplexes Signal empfängt, dessen Argument den Phasenfehler $\Delta\varphi = \varphi_{lokal} - \varphi_{empfangen}$ beinhaltet und das die Regelung der Phase $\varphi_{lokal}$ des lokalen Trägers auf die $\varphi_{empfangen}$ des empfangenen Trägers zulässt.

FIG.1

EP 2 388 620 B1

EP 2 388 620 B1

FIG.2

FIG.3

FIG.4

FIG.5

FIG.6

FIG.7

Discriminateur enrouleur :

$Z_n = I_n + jQ_n$     $Z_n.Z_{n-1}^*$     $I_n' = x$     $\Delta\theta_n$

$I_n$ →

$Q_n$ →

$Z^{-1}$  conj

$Z_{n-1}$     $Z_{n-1}^*$

Produit complexe

real
imag

$Q_n' = y$

Atan(x,y) $[-\pi, \pi]$

Intégrateur

$\theta_n$

$Z^{-1}$

$\theta_{n-1}$

91

Discriminateur enrouleur étendu en fréquence :

$Z_n = I_n + jQ_n$     $Z_n.Z_n'^*$     $I_n' = x$     $\Delta\theta_n$

$Z(n,k)$ →

Intégration cohérente

$Z^{-1}$  conj

$Z_{n-1}$

Produit complexe

real
imag

$Q_n' = y$

Atan(x,y) $[-\pi, \pi]$

$\Delta\theta_n'$

Intégrateur

$\theta_n$

$Z^{-1}$

$\theta_{n-1}$

105

Discriminateur de fréquence

$e^{-i\Delta\theta n'}$

Produit complexe

$Z_n'^*$

921

922

92

FIG.8

EP 2 388 620 B1

FIG.9

EP 2 388 620 B1

$\| Z_{gauche} \|^2$

$\| Z_{droite} \|^2$

$-F_0$   0   $F_0$   f

(erreur de fréquence Doppler)

$\| Z_{droite} \|^2 - \| Z_{gauche} \|^2$

FIG.10

EP 2 388 620 B1

FIG.11

EP 2 388 620 B1

$(p_0-1).F_0$  $p_0.F_0$  $(p_0+1).F_0$  $0$  $f$

(erreur de fréquence Doppler)

FIG.12

FIG.13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   FR 0701931